# FASCICULE DE BREVET EUROPEEN

(11) **EP 0 920 133 B1**
(45) Date de publication et mention de la délivrance du brevet: **14.07.2004**
(21) Numéro de dépôt: 98410132.9
(22) Date de dépôt: 24.11.1998
(51) Int. Cl.: H03K 19/003, H03K 19/00

(54) **Amplificateur de sortie pour circuit intégré**
Ausgangsverstärker für integrierten Schaltkreis
Output amplifier for an integrated circuit

(30) Priorité: 26.11.1997 FR 9715107
(43) Date de publication de la demande: 02.06.1999
(73) Titulaire: STMicroelectronics S.A., 92120 Montrouge (FR)
(72) Inventeur: Tournier, Christian, 38170 Seyssinet-Pariset (FR)
(74) Mandataire: de Beaumont, Michel

(56) Documents cités:
- EP-A- 0 575 676
- US-A- 4 825 099
- US-A- 5 329 177
- US-A- 5 451 861
- US-A- 5 656 960

## Description

La présente invention concerne un amplificateur de sortie, notamment pour un plot de circuit intégré.

Un plot de sortie d'un circuit intégré est classiquement relié à un potentiel d'alimentation haut par un transistor MOS à canal P et à un potentiel d'alimentation bas par un transistor MOS à canal N. Ces deux transistors sont généralement commandés en opposition de phase sans chevauchement, c'est-à-dire que chacun des transistors n'est rendu conducteur que si l'autre est effectivement bloqué. On évite ainsi un appel de courant important qui se produirait pendant un intervalle de temps où les deux transistors conduisent en même temps.

Les technologies deviennent de plus en plus rapides, de sorte que les fronts de commutation des signaux sur les plots de sortie deviennent de plus en plus raides.

Dans certaines applications, on souhaite fournir des signaux logiques de fréquence élevée. Il est alors utile que les signaux aient des fronts raides.

Par contre, dans certaines applications, par exemple dans un téléviseur, les signaux logiques externes au circuit intégré ont une fréquence basse par rapport à la fréquence maximale male de fonctionnement du circuit intégré, et ces signaux ont fronts excessivement raides qui génèrent des ondes électromagnétiques de large spectre. Ces ondes électromagnétiques risquent de perturber le fonctionnement de circuits environnants. Il existe même des normes tendant à limiter les émissions d'ondes électromagnétiques.

On souhaite donc réduire l'émission d'ondes électromagnétiques des circuits intégrés fournissant des signaux logiques de relativement basse fréquence.

Un objet de la présente invention est de prévoir un amplificateur de sortie générant des ondes électromagnétiques de faible amplitude et de spectre étroit.

Pour atteindre cet objet, la présente invention prévoit un amplificateur pour signaux logiques comprenant un transistor de sortie MOS de premier type de conductivité relié par sa source à un premier potentiel d'alimentation, le drain de ce transistor constituant une borne de sortie de l'amplificateur ; un transistor de commande du transistor de sortie relié entre la grille du transistor de sortie et un deuxième potentiel d'alimentation ; un troisième transistor du premier type de conductivité connecté entre la grille du transistor de sortie et le premier potentiel d'alimentation et commandé pour maintenir la tension grille-source du transistor de sortie proche d'une tension seuil de manière que le transistor de sortie fonctionne en générateur de courant ; et un quatrième transistor connecté pour rendre flottante la grille du troisième transistor lorsque le potentiel sur la borne de sortie est proche du premier potentiel d'alimentation.

Selon un mode de réalisation de la présente invention, le quatrième transistor est connecté entre la grille du troisième transistor et la grille du transistor de sortie et est commandé par la borne de sortie.

Selon un mode de réalisation de la présente invention, l'amplificateur comprend un cinquième transistor connecté pour court-circuiter le transistor de commande lorsque le potentiel sur la borne de sortie tend vers le deuxième potentiel d'alimentation.

Selon un mode de réalisation de la présente invention, l'amplificateur comprend un sixième transistor connecté pour forcer la grille du troisième transistor au premier potentiel d'alimentation après le blocage du quatrième transistor lorsque le potentiel sur la borne de sortie tend vers le premier potentiel d'alimentation.

Selon un mode de réalisation de la présente invention, le sixième transistor est du premier type de conductivité et commandé à partir de la sortie d'un inverseur à hystérésis.

Selon un mode de réalisation de la présente invention, l'amplificateur comprend un septième transistor connecté pour former un transistor d'entrée d'un miroir de courant dont un transistor de sortie est constitué par le troisième transistor, le quatrième transistor étant connecté entre le septième transistor et la grille du troisième transistor, et le fonctionnement en générateur de courant du transistor de sortie étant obtenu par un dimensionnement du transistor de commande et du troisième transistor.

Selon un mode de réalisation de la présente invention, l'amplificateur comprend des transistors complémentaires au transistor de sortie, au transistor de commande et aux troisième, quatrième et septième transistors, connectés de manière symétrique aux potentiels d'alimentation et à la borne de sortie, le septième transistor et son complémentaire étant reliés l'un à l'autre par une charge résistive.

Selon un mode de réalisation de la présente invention, l'amplificateur comprend un huitième transistor du premier type de conductivité connecté entre la grille du transistor de sortie et le premier potentiel d'alimentation et des moyens pour connecter ce huitième transistor en parallèle par toutes ses bornes sur le troisième transistor lorsqu'un signal de commande est à un état actif.

Selon un mode de réalisation de la présente invention, l'amplificateur comprend des moyens pour annuler la tension grille-source du huitième transistor lorsque le signal de commande est à un état inactif.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente partiellement un amplificateur de sortie constituant une étape préliminaire dans la réalisation d'un amplificateur de sortie selon l'invention ;
la figure 2 représente un premier mode de réalisation d'amplificateur de sortie selon l'invention ;
la figure 3 représente un deuxième mode de réalisation constituant une première amélioration de l'amplificateur de la figure 2 ;
la figure 4 représente l'évolution de signaux de l'amplificateur de la figure 3 afin d'illustrer son fonctionnement ;
la figure 5 représente un troisième mode de réalisation constituant une deuxième amélioration de l'amplificateur de la figure 2 ;
la figure 6 représente un quatrième mode de réalisation d'amplificateur de sortie selon la présente invention ; et
la figure 7 représente une variante du mode de réalisation de la figure 2 permettant de choisir la pente du signal de sortie de l'amplificateur parmi plusieurs valeurs.

Afin de réduire l'émission d'ondes électromagnétiques, la présente invention prévoit de réduire la pente des fronts de la tension fournie par l'amplificateur de sortie. Bien entendu, ceci implique que le signal logique fourni par l'amplificateur ait une fréquence suffisamment basse pour ne pas subir d'atténuation sensible du fait de la réduction des pentes des fronts.

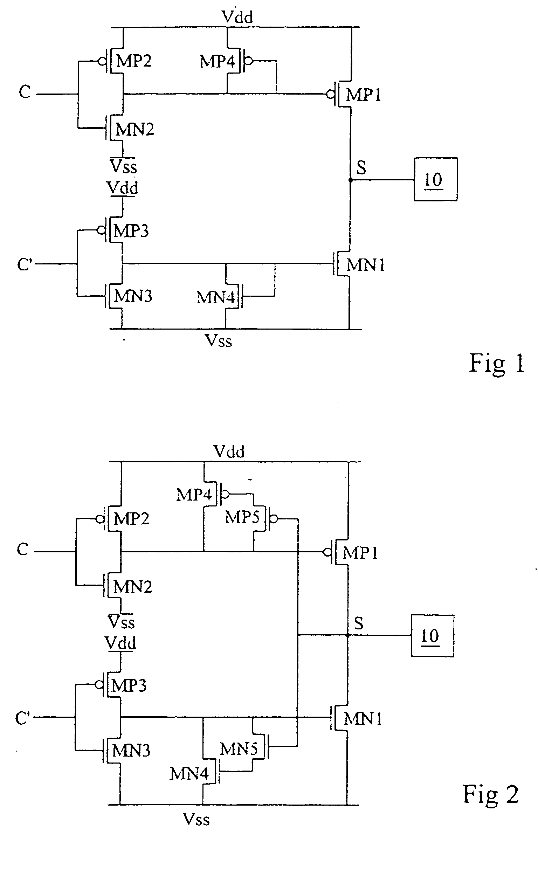

La figure 1 représente partiellement un amplificateur de sortie classique modifié selon une étape préliminaire de l'invention pour réduire les pentes de la tension de sortie.

L'amplificateur comprend un transistor MOS à canal P MP1 et un transistor MOS à canal N MN1 dont les drains sont reliés l'un à l'autre et constituent la sortie S de l'amplificateur. Cette sortie S est reliée à un plot 10 de circuit intégré. Les sources des transistors MP1 et MN1 sont respectivement reliées à un potentiel d'alimentation haut Vdd et à un potentiel d'alimentation bas Vss.

Chacun des transistors MP1 et MN1 est généralement commandé de manière indépendante par un inverseur respectif. L'inverseur qui commande le transistor MP1 est constitué d'un transistor MOS à canal P MP2 et d'un transistor MOS à canal N MN2 reliés en série entre les potentiels d'alimentation Vdd et Vss. Les grilles des transistors MP2 et MN2 reçoivent un même signal de commande C. L'inverseur associé au transistor MN1 est constitué d'un transistor MOS à canal P MP3 et d'un transistor MOS à canal N MN3 reliés en série entre les potentiels d'alimentation Vdd et Vss. Les grilles des transistors MP3 et MN3 reçoivent un signal de commande commun C'.

Les signaux de commande C et C' sont sous la forme de créneaux de même polarité, les créneaux positifs du signal C étant moins larges que les créneaux positifs du signal C', et compris à l'intérieur des créneaux positifs du signal C'. On commande ainsi les transistors MP1 et MN1 de manière qu'il n'existe pas de phase où ces deux transistors conduisent en même temps.

Dans un amplificateur de sortie classique, ne comportant pas des transistors MP4 et MN4 qui seront décrits ultérieurement, la grille de chacun des transistors MP1 et MN1 varie pratiquement entre les potentiels Vss et Vdd. Il en résulte que les transistors MP1 et MN1 sont commandés en régime résistif et fournissent des courants qui sont seulement limités par leurs résistances à l'état passant. On obtient alors des fronts de pente maximale sur la tension de sortie.

La présente invention prévoit de faire fonctionner chacun des transistors MP1 et MN1 en générateur de courant sensiblement constant pendant les fronts de la tension de sortie. Pour cela on prévoit les transistors MP4 et MN4. Le transistor MP4 est un transistor MOS à canal P connecté en diode entre la grille du transistor MP1 et le potentiel d'alimentation haut Vdd. Plus spécifiquement, le drain et la grille du transistor MP4 sont reliés à la grille du transistor MP1, tandis que la source du transistor MP4 est reliée au potentiel Vdd. Le transistor MN4, MOS à canal N, est relié de la même manière entre la grille du transistor MN1 et le potentiel Vss.

Avec cette configuration, les transistors MP4, MP1 et MN4, MN1 constituent des miroirs de courant. Le transistor MP1 recopie sur son drain le courant dans le transistor MP4, tandis que le transistor MN1 recopie sur son drain le courant dans le transistor MN4. La recopie de courant s'effectue avec un coefficient multiplicateur qui dépend des rapports W/L des transistors.

Le courant dans le transistor MP1 dépend de la tension d'alimentation Vdd et de la résistance à l'état passant du transistor MN2, tandis que le courant dans le transistor MN1 dépend de la tension d'alimentation Vdd et de la résistance à l'état passant du transistor MP3. Ainsi, les transistors MN2 et MP3, ou bien les transistors MP4 et MN4, sont dimensionnés pour obtenir les courants de sortie souhaités. Comme la charge alimentée par l'amplificateur est généralement capacitive, ces courants de sortie constants confèrent des pentes constantes à la tension de sortie.

Ce circuit a plusieurs inconvénients. Un premier inconvénient est qu'il présente une consommation statique. A tout instant, au moins un des transistors MP1 et MN1 est conducteur, ce qui signifie qu'un courant est toujours fourni à l'un ou l'autre des miroirs de courant MP4, MP1 et MN4, MN1.

Si l'on augmente les résistances à l'état passant des transistors MN2 et MP3 dans le but de réduire le courant statique, on augmente le temps de réponse de l'amplificateur aux signaux de commande C et C'. En effet, les capacités de grille des transistors MP1 et MN1 mettront plus longtemps à se charger, d'où il résulte que l'amplificateur réagira plus lentement à une commutation des signaux C et C'.

Un autre inconvénient de ce circuit est que sa sortie est en permanence limitée en courant, d'où il résulte que l'on n'obtient pas une excursion de tension maximale aux bornes d'une charge résistive de faible valeur.

Ces inconvénients limitent considérablement le champ d'application du circuit de la figure 1.

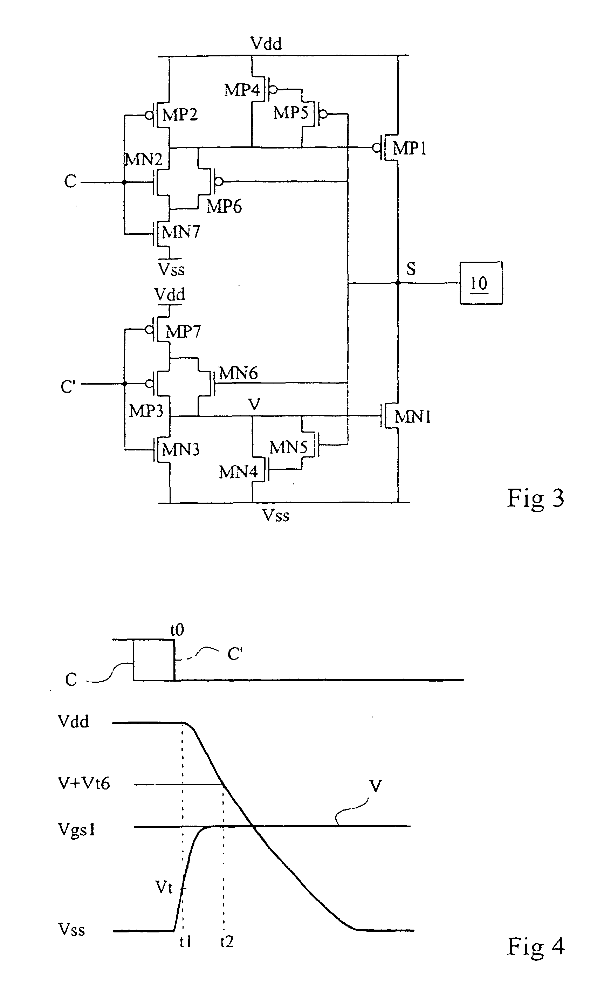

La figure 2 représente une modification selon l'invention du circuit de la figure 1 permettant d'éviter la plupart des inconvénients susmentionnés.

Les grilles des transistors MP4 et MN4 sont ici connectées aux grilles des transistors MP1 et MN1 par l'intermédiaire de transistors MOS respectifs MP5 et MN5. Les transistors MP5 et MN5 sont respectivement à canal P et à canal N. Les grilles de ces transistors MP5 et MN5 sont toutes deux connectées à la sortie S de l'amplificateur.

Pour comprendre le fonctionnement de ce circuit, on suppose, par exemple, que la sortie S est à l'état haut Vdd, c'est-à-dire que les signaux C et C' sont également à Vdd. Ainsi, le transistor MP1 est conducteur, ce qui implique que le transistor MN2 est également conducteur. Toutefois, le transistor MP5 est bloqué, d'où il résulte que le transistor MP4 est également bloqué et il ne subsiste donc aucun chemin de courant entre le transistor MN2 et le potentiel Vdd. Ainsi, le transistor MN2 peut tirer pratiquement jusqu'au potentiel bas Vss la grille du transistor MP1 qui fonctionne donc en régime résistif et fournit un courant maximal sur la sortie S.

La sortie S étant à l'état haut, le transistor MN5 est conducteur, d'où il résulte que le transistor MN4 est connecté pour former un miroir de courant comme dans la figure 1. Toutefois, le transistor MP3 est bloqué et il n'existe pas de chemin de courant entre le transistor MN4 et le potentiel Vdd. Le transistor MN1 est bloqué du fait que le transistor MN3 est conducteur et tire sa grille vers le potentiel Vss (le signal C est à Vdd).

Lorsque les signaux de commande C et C' commutent, les transistors MN2 et MN3 se bloquent tandis que les transistors MP2 et MP3 deviennent conducteurs. Le transistor MP2 tire la grille du transistor MP1 vers le potentiel Vdd, d'où il résulte que le transistor MP1 se bloque. La sortie S restant à l'état haut, le transistor MN5 reste conducteur, d'où il résulte que les transistors MN4 et MN1 sont toujours connectés en miroir de courant. Le transistor MP3 alimente en courant le transistor MN4, lequel courant est recopié dans le transistor MN1. Ainsi, le transistor MN1 tire la sortie S vers le potentiel Vss à courant constant, et donc avec une pente limitée dans le cas général où la sortie S alimente une charge capacitive.

Lorsque la tension sur la sortie S est inférieure à la somme des tensions de seuil des transistors MN4 et MN5, le transistor MN5 se bloque, mais le transistor MN4 continue à fonctionner dans les mêmes conditions, puisque sa tension de grille est maintenue quelque temps par effet capacitif. Ainsi, l'effet de miroir de courant se poursuit tant que la capacité de grille du transistor MN4 ne s'est pas déchargée par effet de fuite en dessous de sa tension seuil. Cette décharge peut se prolonger au-delà de l'instant où la tension sur la sortie S a atteint le niveau Vss. Lorsque la capacité de grille du transistor MN4 est déchargée, le transistor MN4 se bloque et il ne subsiste aucun chemin de courant entre le transistor MP3, qui est alors conducteur, et le potentiel Vss. Le transistor MP3 tire la grille du transistor MN1 vers le potentiel Vdd, d'où il résulte que le transistor MN1 se met à fonctionner en régime résistif et tire un courant maximal de la sortie S.

Le niveau de la sortie S étant alors bas, le transistor MP5 est conducteur et connecte le transistor MP4 selon la configuration de miroir de courant de la figure 1. Toutefois le transistor MN2 est bloqué et il ne subsiste aucun chemin de courant entre le transistor MP4 et le potentiel Vss.

Bien entendu, le fonctionnement est symétrique lorsque la sortie S passe de l'état 0 à l'état 1.

Étant donné que le circuit ne consomme aucun courant statique du fait que l'un ou l'autre des transistors MN2 et MP3 est conducteur, les résistances à l'état passant de ces transistors peuvent être choisies relativement faibles afin de permettre une charge rapide des capacités de grille des transistors MP1 et MN1 et donc une réponse rapide aux commutations des signaux de commande C et C'. On pourra agir sur la valeur de ces résistances et sur les rapports W/L des transistors MN1, MN4, MP1 et MP4 pour régler à la fois le courant de sortie souhaité pendant les commutations et le temps de réponse.

Afin d'obtenir une vitesse de réponse maximale, il suffit en fait que le courant de charge des grilles des transistors MP1 et MN1 soit maximal pendant la durée de la charge des grilles de ces transistors jusqu'à leurs tensions seuil. Au-delà de cette durée, ce courant maximal est inutile et provoque une importante consommation de courant à la commutation.

La figure 3 représente une modification selon l'invention du circuit de la figure 2 permettant d'obtenir une réponse rapide de l'amplificateur tout en limitant sa consommation à la commutation. Dans ce mode de réalisation, un transistor MOS à canal P MP6 est relié en parallèle sur le transistor MN2, et un transistor MOS à canal N MN6 est relié en parallèle sur le transistor MP3. Les grilles des transistors MP6 et MN6 sont connectées à la sortie S de l'amplificateur. Par ailleurs, un transistor MOS à canal N MN7 est relié entre le potentiel Vss et le transistor MN2 et un transistor MOS à canal P MP7 est relié entre le potentiel Vdd et le transistor MP3.

Les transistors MP6, MN7, MN6 et MP7 sont dimensionnés pour avoir une faible résistance à l'état passant car ils devront assurer une charge rapide des capacités de grille des transistors MP1 et MN1 pour diminuer le temps de réponse de l'amplificateur. Les transistors MN2 et MP3 sont dimensionnés indépendamment des transistors MP6, MN7, MN6 et MP7 pour régler le courant des transistors MP1 et MN1 lors des commutations.

La figure 4 représente l'évolution de divers signaux pour illustrer le fonctionnement du circuit de la figure 3. La figure 4 représente notamment l'évolution de la tension S sur la borne de sortie de l'amplificateur et de la tension V sur la grille du transistor MN1, dans l'exemple où les signaux de commande C et C' passent de l'état 1 à l'état 0.

Initialement, les signaux C et C' sont à 1, d'où il résulte que la sortie S est à 1 (Vdd). Le transistor MN6 court-circuite donc le transistor MP3 qui n'est pas conducteur pour l'instant.

Avant un instant t0, le signal C passe à l'état 0 pour bloquer le transistor MP1 avant que le transistor MN1 ne soit rendu conducteur.

A l'instant t0, le signal C' passe à l'état 0. Alors, les transistors MP7 et MP3 deviennent conducteurs et le transistor MN3 se bloque. Le transistor MP3 est toujours court-circuité par le transistor MN6, d'où il résulte que la grille du transistor MN1, qui était tirée au potentiel bas Vss par le transistor MN3, est chargée par un courant important déterminé par la faible résistance à l'état passant des transistors MP7 et MN6. Ainsi, la tension V croît rapidement.

A un instant t1, la tension V atteint la tension de seuil Vt des transistors MN1 et MN4. Les transistors MN1 et MN4 commencent alors à fonctionner en miroir de courant et le transistor MN1 commence à conduire. Mais la tension de grille V du transistor MN1 doit atteindre une valeur Vgsl pour que ce transistor recopie effectivement le courant important imposé par les transistors MP7 et MN6. La tension S se met à décroître à partir de l'instant t1 et atteint une pente maximale lorsque la tension V atteint la valeur Vgs1.

A un instant t2, la tension S atteint la valeur de la tension V augmentée de la tension de seuil Vt6 du transistor MN6. A partir de cet instant, le transistor MN6 est bloqué. Alors le courant dans le transistor MN4, recopié dans le transistor MN1, dépend des résistances en série des transistors MP7 et MP3. La résistance du transistor MP3 est élevée par rapport à celle du transistor MN6, d'où il résulte que le courant de sortie diminue et la pente de la tension S devient faible à partir de l'instant t2, comme cela est souhaité. En réalité, les commutations décrites sont progressives, ce qui produit, comme cela est représenté, un signal de sortie S dont la pente varie progressivement.

La résistance du transistor MP3 peut être choisie particulièrement élevée pour diminuer la consommation de courant à partir de l'instant t2 sans que cela n'affecte la vitesse de réponse. En effet, la vitesse de réponse est déterminée par le courant important circulant brièvement entre les instants t0 et t2. La pente de la tension S est réglée à la valeur souhaitée en choisissant convenablement les rapports W/L des transistors MN1 et MN4.

Comme précédemment, lorsque la tension S passe en dessous de la somme des tensions seuil des transistors MN4 et MN5, le transistor MN5 se bloque, mais le transistor MN4 conserve son comportement le temps que sa capacité de grille se décharge. Ceci permettra généralement à la tension S d'atteindre la valeur Vss en conservant la même pente, comme cela est représenté.

Bien entendu, le fonctionnement est symétrique lorsque les signaux de commande C et C' passent de l'état 0 à l'état 1.

Un inconvénient des circuits des figures 2 et 3 est que l'on ne maîtrise pas la décharge de la capacité de grille du transistor MN4 lorsque le transistor MN5 est bloqué. Il n'est pas souhaitable que la charge de grille du transistor MN4 soit maintenue longuement au delà de l'instant où le signal S atteint la valeur basse Vss, car ceci provoquerait un certain courant statique circulant dans les transistors MP3 et MN4. Ce phénomène est accentué dans un milieu bruité, des pics de bruit pouvant de temps à autre rendre le transistor MN4 conducteur du fait que sa tension de grille est au voisinage du seuil de conduction.

Les mêmes problèmes se posent pour le transistor MP4 dans l'état complémentaire de l'amplificateur.

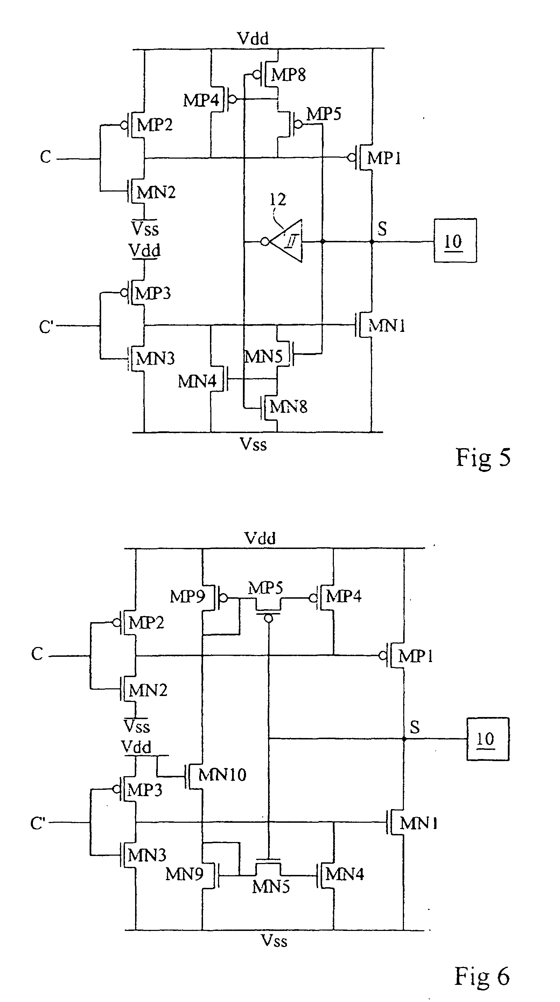

La figure 5 représente une modification selon l'invention du circuit de la figure 2 permettant d'éviter ces inconvénients.

La grille du transistor MP4 est reliée au potentiel Vdd par un transistor MOS à canal P MP8, tandis que la grille du transistor MN4 est reliée au potentiel Vss par un transistor MOS à canal N MN8. Les grilles des transistors MP8 et MN8 sont commandées par un inverseur à hystérésis 12 dont l'entrée est connectée à la borne de sortie S de l'amplificateur. L'inverseur à hystérésis 12 est prévu pour commuter à l'état haut lorsque sa tension d'entrée S chute en dessous d'un seuil compris entre 0 (Vss) et la somme des tensions seuil des transistors MN4 et MN5. Bien entendu, l'inverseur 12 fonctionne de manière symétrique et commute vers un état bas lorsque sa tension d'entrée S dépasse un seuil compris entre le potentiel Vdd et le potentiel Vdd diminué de la somme des seuils des transistors MP4 et MP5.

Ainsi, si la sortie S est, par exemple, initialement à 1, la sortie de l'inverseur 12 est à 0 et bloque le transistor MN8. On retrouve alors les conditions initiales exposées à titre d'exemple en relation avec la figure 2. Lorsque les signaux C et C' basculent, le transistor MP3 devient conducteur et fournit au transistor MN4 un courant qui est recopié dans le transistor MN1. La tension de sortie S décroît alors progressivement. Lorsque la sortie S atteint la somme des tensions seuil des transistors MN4 et MN5, le transistor MN5 se bloque, mais le transistor MN4 conserve son comportement du fait que sa tension de grille est mémorisée par effet capacitif. La tension S continue à décroître progressivement et finit par atteindre le seuil de commutation de l'inverseur 12. Alors l'inverseur 12 rend conducteur le transistor MN8 qui décharge la capacité de grille du transistor MN4 et bloque ce dernier. Le transistor MP3 fait alors augmenter la tension de grille du transistor MN1 qui atteint son régime de fonctionnement résistif au voisinage de l'instant où la tension S atteint la valeur Vss.

Bien entendu, on obtient un fonctionnement symétrique lorsque la tension S passe de l'état bas à l'état haut.

La figure 6 représente un mode de réalisation d'amplificateur de sortie selon l'invention permettant un appariement relativement précis des pentes ascendantes et des pentes descendantes de la tension de sortie de l'amplificateur. Le transistor MP5, au lieu d'être relié au potentiel Vdd, est relié à la grille d'un transistor MOS à canal P MP9 connecté en diode. De même, le transistor MN5, au lieu d'être relié au potentiel Vss, est relié à la grille d'un transistor MOS à canal N MN9 connecté en diode. Les sources des transistors MP9 et MN9 sont reliées respectivement au potentiel Vdd et Vss. Les drains des transistors MP9 et MN9 sont reliés l'un à l'autre par l'intermédiaire d'un transistor MOS à canal N MN10. La grille du transistor MN10 est connectée au potentiel haut Vdd, de sorte que le transistor MN10 fonctionne en régime résistif. Le courant, identique, circulant dans les transistors MP9 et MN9 est déterminé par les transistors MN9, MP9 et MN10, et par la tension d'alimentation Vdd. Les rapports W/L des transistors MP4, MP1 et MN4, MN1, permettent le réglage précis des pentes ascendantes et descendantes.

Lorsque la sortie S est à l'état haut Vdd, le transistor MN5 est conducteur, de sorte que les transistors MN9 et MN4 se comportent en miroir de courant, le transistor MN4 recopiant sur son drain le courant du transistor MN9.

Lorsque les signaux de commande C et C' commutent, le transistor MP3 devient conducteur et tend à faire croître la tension de grille du transistor MN1. Les dimensions des transistors MP3 et MN4 sont choisies pour que la tension de grille du transistor MN1 soit sensiblement égale à la tension de grille ou de drain du transistor MN9, de sorte que le transistor MN1 recopie également le courant du transistor MN9. On obtient alors le fonctionnement décrit en relation avec la figure 2.

Un fonctionnement symétrique est obtenu lorsque la sortie S commute de l'état bas Vss vers l'état haut Vdd, le transistor MP1 recopiant le courant du transistor MP9, identique au courant du transistor MN9.

Le circuit de la figure 6 présente l'inconvénient d'avoir une consommation statique. Cette consommation statique peut toutefois être réduite à un minimum en jouant sur les rapports W/L des transistors MP4, MP9 et MN4, MN9, les courants des transistors MP4 et MN4 étant amplifiés sans augmenter le retard de réponse de l'amplificateur.

Bien entendu, les modes de réalisation des figures 3, 5 et 6 peuvent être combinés.

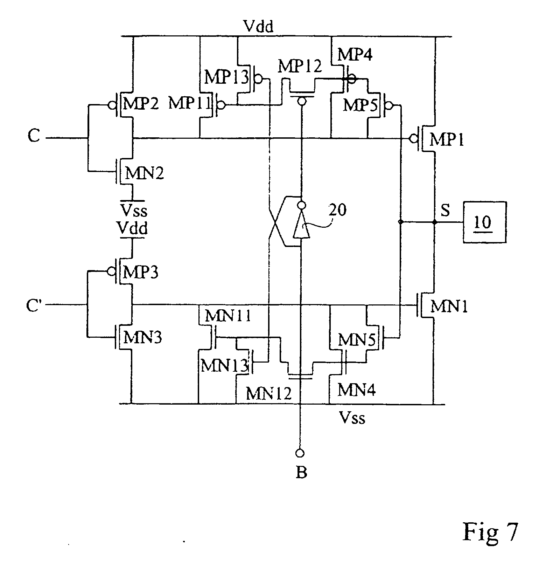

La figure 7 représente une variante du circuit de la figure 2 permettant de choisir la pente du signal de sortie S de l'amplificateur parmi plusieurs valeurs possibles (deux valeurs dans l'exemple de la figure 7). Un transistor MOS à canal P MP11 est connecté, comme le transistor MP4, entre la grille du transistor MP1 et la ligne d'alimentation Vdd. De même, un transistor MOS à canal N MN11 est connecté comme le transistor MN4 entre la grille du transistor MN1 et la ligne d'alimentation Vss. La grille du transistor MP11 est reliée à la grille du transistor MP4 par l'intermédiaire d'un transistor MOS à canal P MP12. De même, la grille du transistor MN11 est reliée à la grille du transistor MN4 par l'intermédiaire d'un transistor MOS à canal N MN12. Un signal de commande logique B est appliqué sur la grille du transistor MN12. Ce même signal B est appliqué sur la grille du transistor MP12 par l'intermédiaire d'un inverseur 20.

Avec cette configuration, lorsque le signal B est mis à 1, les transistors MN12 et MP12 deviennent conducteurs et connectent les transistors MP11 et MN11 en parallèle, respectivement, sur les transistors MP4 et MN4. Il en résulte que le facteur de recopie de courant dans les transistors MP1 et MN1 diminue d'une quantité dépendant des rapports W/L des transistors MP4, MP11, MN4 et MN11.

Plusieurs autres transistors peuvent être connectés aux transistors MP4 et MN4 comme les transistors MP11 et MN11, ces autres transistors étant commandés par d'autres signaux correspondant, avec le signal B, aux bits d'un signal de commande numérique. On peut ainsi régler la pente du signal de sortie de manière précise.

Afin d'éviter le flottement des grilles des transistors MP11 et MN11 lorsque les transistors MP12 et MN12 sont bloqués, on prévoit un transistor MOS à canal P MP13 connecté entre la grille du transistor MP11 et le potentiel Vdd, ainsi qu'un transistor MOS à canal N MN13 connecté entre la grille du transistor MN11 et le potentiel Vss. Le transistor MP13 est commandé par le signal B tandis que le transistor MN13 est commandé par la sortie de l'inverseur 20. Ainsi, lorsque les transistors MP12 et MN12 sont bloqués, les transistors MP13 et MN13 sont conducteurs et provoquent l'annulation des tensions grille-source des transistors MP11 et MN11.

La présente invention est susceptible de diverses variantes et modifications qui apparaîtront à l'homme du métier. Par exemple, les transistors MP5 et MN5 peuvent être remplacés par des transistors de types de conductivité inverses et être commandés par un inverseur.

## Revendications

1. Amplificateur pour signaux logiques comprenant :
- un transistor de sortie MOS (MN1) de premier type de conductivité relié par sa source à un premier potentiel d'alimentation (Vss), le drain de ce transistor constituant une borne de sortie (S) de l'amplificateur ;
- un transistor de commande (MP3) du transistor de sortie relié entre la grille du transistor de sortie et un deuxième potentiel d'alimentation (Vdd) ;
**caractérisé en ce qu'**il comprend :
- un troisième transistor (MN4) du premier type de conductivité connecté entre la grille du transistor de sortie et le premier potentiel d'alimentation (Vss) et commandé pour maintenir la tension grille-source du transistor de sortie proche d'une tension seuil (Vt) de manière que le transistor de sortie fonctionne en générateur de courant ; et
- un quatrième transistor (MN5) connecté pour rendre flottante la grille du troisième transistor (MN4) lorsque le potentiel sur la borne de sortie (S) est proche du premier potentiel d'alimentation.

2. Amplificateur selon la revendication 1, **caractérisé en ce que** le quatrième transistor (MN5) est connecté entre la grille du troisième transistor (MN4) et la grille du transistor de sortie et est commandé par la borne de sortie (S).

3. Amplificateur selon la revendication 1, **caractérisé en ce qu'**il comprend un cinquième transistor(MN6) connecté pour court-circuiter le transistor de commande (MP3) lorsque le potentiel sur la borne de sortie (S) tend vers le deuxième potentiel d'alimentation (Vdd).

4. Amplificateur selon la revendication 1, **caractérisé en ce qu'**il comprend un sixième transistor (MN8) connecté pour forcer la grille du troisième transistor (MN4) au premier potentiel d'alimentation (Vss) après le blocage du quatrième transistor (MN5) lorsque le potentiel sur la borne de sortie tend vers le premier potentiel d'alimentation.

5. Amplificateur selon la revendication 4, **caractérisé en ce que** le sixième transistor (MN8) est du premier type de conductivité et commandé à partir de la sortie d'un inverseur à hystérésis.

6. Amplificateur selon la revendication 1, **caractérisé en ce qu'**il comprend un septième transistor (MN9) connecté pour former un transistor d'entrée d'un miroir de courant dont un transistor de sortie est constitué par le troisième transistor (MN4), le quatrième transistor (MN5) étant connecté entre le septième transistor et la grille du troisième transistor, et le fonctionnement en générateur de courant du transistor de sortie (MN1) étant obtenu par un dimensionnement du transistor de commande (MP3) et du troisième transistor (MN4).

7. Amplificateur selon la revendication 6, **caractérisé en ce qu'**il comprend des transistors (MP1, MN2, MP4, MP5, MP9) complémentaires au transistor de sortie, au transistor de commande et aux troisième, quatrième et septième transistors, connectés de manière symétrique aux potentiels d'alimentation et à la borne de sortie (S), le septième transistor (MN9) et son complémentaire (MP9) étant reliés l'un à l'autre par une charge résistive (MN10).

8. Amplificateur selon la revendication 1, **caractérisé en ce qu'**il comprend un huitième transistor (MN11) du premier type de conductivité connecté entre la grille du transistor de sortie et le premier potentiel d'alimentation (Vss) et des moyens pour connecter ce huitième transistor en parallèle par toutes ses bornes sur le troisième transistor lorsqu'un signal de commande (B) est à un état actif.

9. Amplificateur selon la revendication 8, **caractérisé en ce qu'**il comprend des moyens pour annuler la tension grille-source du huitième transistor lorsque le signal de commande est à un état inactif.

## Patentansprüche

1. Verstärker für logische Signale, welcher umfasst:
- einen MOS-Ausgangstransistor (MN1) vom ersten Leitfähigkeitstyp, der mit seinem Source-Anschluss mit einem ersten Speisepotential (Vss) verbunden ist, wobei der Drain-Anschluss dieses Transistors einen Ausgangsanschluss (S) des Verstärkers bildet;
- einen zwischen dem Gate des Ausgangstransistors und einem zweiten Speisepotential (Vdd) liegenden Steuertransistor (MP3) für den Ausgangstransistor;
**dadurch gekennzeichnet, dass** der Verstärker umfasst:
- einen dritten Transistor (MN4) vom ersten Leitfähigkeitstyp, der zwischen dem Gate des Ausgangstransistors und dem ersten Speisepotential (Vss) angeschlossen ist und so gesteuert wird, dass die Gate-Source-Spannung des Ausgangstransistors nahe einer Schwellspannung (Vt) gehalten wird, derart daß der Ausgangstransistor als Stromgenerator arbeitet; sowie
- einen vierten Transistor (MN5) in solcher Schaltung, dass er das Gate des dritten Transistors (MN4) flottieren lässt, wenn das Potential am Ausgangsanschluss (S) nahe dem ersten Speisepotential liegt.

2. Verstärker nach Anspruch 1, **dadurch gekennzeichnet, dass** der vierte Transistor (MN5) zwischen dem Gate des dritten Transistors (MN4) und dem Gate des Ausgangstransistors angeschlossen ist und durch den Ausgangsanschluss (S) gesteuert wird.

3. Verstärker nach Anspruch 1, **dadurch gekennzeichnet, dass** er einen fünften Transistor (MN6) in solcher Schaltverbindung umfasst, dass er den Steuertransistor (MP3) kurzschließt, wenn das Potential an der Ausgangsklemme (S) sich in Richtung auf das zweite Speisepotential (Vdd) bewegt.

4. Verstärker nach Anspruch 1, **dadurch gekennzeichnet, dass** er einen sechsten Transistor (MN8) in solcher Schaltanordnung aufweist, dass er das Gate des dritten Transistors (MN4) auf das erste Speisepotential (Vss) zwangssteuert, nach Sperrung des vierten Transistors (MN5), wenn das Potential am Ausgangsanschluss sich in Richtung auf das erste Speisepotential bewegt.

5. Verstärker nach Anspruch 4, **dadurch gekennzeichnet, dass** der sechste Transistor (MN8) vom ersten Leitfähigkeitstyp ist und vom Ausgang eines Hysterese-Inverters gesteuert wird.

6. Verstärker nach Anspruch 1, **dadurch gekennzeichnet, dass** er einen siebenten Transistor (MN9) in solcher Schaltverbindung aufweist, dass er einen Eingangstransistor eines Stromspiegels bildet, von dem ein Ausgangstransistor durch den dritten Transistor (MN4) gebildet wird, dass der vierte Transistor (MN5) zwischen dem siebenten Transistor und dem Gate des dritten Transistors angeschlossen ist, und dass die Arbeitsweise des Ausgangstransistors (MN1) als Stromgenerator durch eine Dimensionierung des Steuertransistors (MP3) und des dritten Transistors (MN4) erhalten wird.

7. Verstärker nach Anspruch 6, **dadurch gekennzeichnet, dass** er zu dem Ausgangstransistor, dem Steuertransistor und dem dritten, vierten und siebenten Transistor komplementäre Transistoren (MP1, MN2, MP4, MP5, MP9) aufweist, jeweils in symmetrischer Anschlussverbindung bezüglich der Speisepotentiale und dem Ausgangsanschluss (S), und dass der siebente Transistor (MN9) und sein komplementärer Transistor (MP9) miteinander durch eine Widerstands last (MN10) verbunden sind.

8. Verstärker nach Anspruch 1, **dadurch gekennzeichnet, dass** er einen achten Transistor (MN11) vom ersten Leitfähigkeitstyp in Anschlussverbindung zwischen dem Gate des Ausgangstransistors und dem ersten Speisepotential (Vss) aufweist sowie Mittel, um diesen achten Transistor mit allen seinen Anschlüssen parallel zum dritten Transistor zu legen, sobald ein Steuersignal (B) sich in einem aktiven Zustand befindet.

9. Verstärker nach Anspruch 8, **dadurch gekennzeichnet, dass** er Mittel umfasst, um die Gate-Source-Spannung des achten Transistors zu annullieren, wenn das Steuersignal sich in einem inaktiven Zustand befindet.

## Claims

1. A buffer for logic signals including:
- a MOS output transistor (MN1) of a first conductivity type connected by its source to a first supply potential (Vss), the drain of this transistor forming an output terminal (S) of the buffer;
- a control transistor (MP3) for controlling the output transistor, connected between the gate of the output transistor and a second supply potential (Vdd);
**characterized in that** it comprises:
- a third transistor (MN4) of the first conductivity type connected between the gate of the output transistor and the first supply potential (Vss) and controlled to maintain the gate-source voltage of the buffer close to a threshold voltage (Vt) so that the output transistor operates as a current generator; and
- a fourth transistor (MN5) connected to render floating the gate of the third transistor (MN4) when the potential on the output terminal (S) is close to the first supply potential.

2. The buffer of claim 1, **characterized in that** the fourth transistor (MN5) is connected between the gate of the third transistor (MN4) and the gate of the output transistor and is controlled by the output terminal (S).

3. The buffer of claim 1, **characterized in that** it includes a fifth transistor (MN6) connected to short-circuit the control transistor (MP3) when the potential on the output terminal (S) tends towards the second supply potential (Vdd).

4. The buffer of claim 1, **characterized in that** it includes a sixth transistor (MN8) connected to force the gate of the third transistor (MN4) to the first supply potential (Vss) after turning-off of the fourth transistor (MN5) when the potential on the output terminal tends towards the first supply potential.

5. The buffer of claim 4, **characterized in that** the sixth transistor (MN8) is of the first conductivity type and is controlled from the output of a hysteresis inverter.

6. The buffer of claim 1, **characterized in that** it includes a seventh transistor (MN9) connected to form an input transistor of a current mirror, an output transistor of which is formed by the third transistor (MN4), the fourth transistor (MN5) being connected between the seventh transistor and the gate of the third transistor, and the operation as a current generator of the output transistor (MN1) being obtained by a sizing of the control transistor (MP3) and of the third transistor (MN4).

7. The buffer of claim 6, **characterized in that** it includes transistors (MP1, MN2, MP4, MP5, MP9) complementary to the output transistor, the control transistor, and the third, fourth, and seventh transistors, connected symmetrically to the supply potentials and to the output terminal (S), the seventh transistor (MN9) and its complement (MP9) being interconnected by a resistive load (MN10).

8. The buffer of claim 1, **characterized in that** it includes an eighth transistor (MN11) of the first conductivity type connected between the gate of the output transistor and the first supply potential (Vss) and means for connecting this eighth transistor in parallel by all its terminals to the third transistor when a control signal (B) is at an active state.

9. The buffer of claim 8, **characterized in that** it includes means for canceling the gate-source voltage of the eighth transistor when the control signal is at an inactive state.
